# EUROPEAN PATENT SPECIFICATION

(11) **EP 1 847 878 B1**
(45) Date of publication and mention of the grant of the patent: **31.10.2012**
(21) Application number: 06713814.9
(22) Date of filing: 09.02.2006
(51) Int. Cl.: G03F 7/42

(54) **PHOTOSENSITIVE COMPOSITION REMOVING LIQUID**
FLÜSSIGKEIT ZUR ENTFERNUNG VON LICHTEMPFINDLICHEN ZUSAMMENSETZUNGEN
SOLUTION D' ELIMINATION D'UNE PREPARATION PHOTOSENSIBLE

(30) Priority: 09.02.2005 JP 2005032879
(43) Date of publication of application: 24.10.2007
(73) Proprietor: SHOWA DENKO K.K., Tokyo 105-8518 (JP)
(72) Inventor: KANEDA, Masato, Yamaguchi, 7460006 (JP); MIKAWA, Yasuhiro, Yamaguchi, 7460006 (JP); TERAO, Kouichi, Yamaguchi, 7460006 (JP)
(74) Representative: Strehl Schübel-Hopf & Partner
(86) International application number: PCT/JP2006/302673
(87) International publication number: WO 2006/085678

(56) References cited:
- WO-A1-03/058350
- JP-A- 01 158 444
- JP-A- 07 128 867
- JP-A- 07 160 008
- JP-A- 11 044 960
- JP-A- 11 218 933
- JP-A- 2000 164 671
- JP-A- 2000 199 971
- JP-A- 2002 341 130
- JP-A- 2003 167 114
- JP-A- 2003 295 477
- US-A- 5 185 235
- US-A- 5 866 305
- US-A1- 2004 029 036

## Description

### Technical Field

The present invention relates to a removing solution for photosensitive composition. More particularly, the invention relates to a removing solution for removal of uncured photosensitive composition films coated on the periphery, edges or backs of substrates, or for removal of uncured photosensitive compositions adhering to the surfaces of device members or equipment in steps of forming photosensitive composition films on glass substrates, semiconductor wafers and the like.

The removing solution for photosensitive composition of the invention is especially useful for removal of uncured pigment-containing photosensitive composition films remaining on the periphery, edges or backs of substrates, or for removal of uncured pigment-containing photosensitive compositions adhering to the surfaces of device members or equipment in steps for formation of photosensitive composition films on substrates during the manufacturing of color filters used in liquid crystal devices or organic EL devices and image sensors.

### Background Art

Pattern formation of photosensitive compositions using lithography techniques is commonly performed in the steps for manufacturing of flat panel displays such as liquid crystals, organic ELs, plasma displays, and semiconductors.

Methods of RGB or resin black matrix pattern formation in the manufacturing of color filters used in liquid crystal devices or organic EL devices, image sensors and the like include pigment dispersion methods, dyeing methods, printing methods and electrodeposition methods. Pigment dispersion methods accomplish patterning of different colors by photolithography using pigment-containing photosensitive compositions, and they are suitable methods for manufacturing of color filters because they form stable colored films. When a photosensitive composition film is formed on a substrate by such methods, one of the processes involves applying the pigment-containing photosensitive composition onto the substrate, where the application is accomplished by a known method such as spin coating, slit coating, wire bar coating, roll coating, dip coating, spray coating or a combination thereof.

For spin coating, it is common to perform rinsing treatment, that is edge rinsing or back rinsing, with a removing solution for photosensitive composition, in order to remove the swelling portions of the photosensitive composition film at the periphery or edges of the substrate, or to remove the photosensitive composition on the back of the substrate, after coating of the photosensitive composition. Photosensitive composition removal is also carried out with a removing solution for photosensitive composition in cup rinsing, which is a step of removing the photosensitive composition that has splashed in the coater-cup during spin coating.

Photosensitive composition application methods for manufacturing of color filters, other than spin coating, include photosensitive composition application by slit coating, application using a wire bar or application with a roll coater, but these methods also require removal of the unnecessary photosensitive composition adhering to all or parts of the application device, such as the slit nozzle or wire bar, after application of the photosensitive composition.

In addition, in some cases the photosensitive composition must also be removed from members of application devices such as the conduits for transport of the photosensitive composition. Such removal of the photosensitive composition is usually accomplished by cleaning treatment using a removing solution.

In any step of removing photosensitive composition adhering to a substrate or apparatus, a problem is posed by the residual photosensitive composition components. Pigment-containing photosensitive compositions used for manufacturing of color filters, i.e. color resists used for RGB formation or black resists used for resin black matrix formation, tend to readily leave residue of the pigment components on substrate or apparatus surfaces, and even small amounts thereof produce contaminants that cause increase of defects during color filter manufacturing, or can potentially degrade the color purity or lower the contrast of the color filter. Color filters used in color displays in recent years increasingly must have large-picture panels, high precision and low cost, and as a result it is becoming more and more important to avoid photosensitive composition component residue that affects color filter performance and yields.

Most conventional removing agents used for photosensitive composition are glycol ethers or their esters, or mixtures thereof (for example, see Japanese Examined Patent Publication No. 4-49938 and Japanese Unexamined Patent Publication No. 7-146562), but when these are applied for cleaning removal of the aforementioned color resists, the resist removability is insufficient, a large amount of removing solution must be used, and removal residue is produced.

Removal of pigment-containing coloring compositions is also achieved by methods that employ solvent components used for the photosensitive composition or components in the photosensitive composition such as surfactants or dispersing agents (for example, see Japanese Unexamined Patent Publication No. 2000-273370), but when only a solvent component in the photosensitive composition is used as the cleaning agent, the pigment. tends to precipitate and adequate cleanability cannot be obtained. When components in the photosensitive composition such as surfactants or dispersing agents are included in the cleaning fluid composition, the components tend to remain on the substrate or apparatus members as vaporization residue, thus requiring a further cleaning step, while the methods are essentially useless for removal of the photosensitive composition from the edges or back of the substrate where evaporation residue is undesirable.

### DISCLOSURE OF THE INVENTION

It is an object of the invention to provide a removing solution for photosensitive composition with excellent photosensitive composition removal performance.

In particular, the invention provides a removing solution that is effective for removal of pigment-containing photosensitive composition films remaining on the periphery, edges or backs of substrates in steps for formation of photosensitive composition films on substrates during the manufacturing of liquid crystal devices or organic EL devices, image sensors and the like, or for removal of pigment-containing photosensitive compositions adhering to the surfaces of device members or equipment.

In the present specification, alkyleneglycol monoalkyl ethers may be referred to as "component 1", aromatic hydrocarbons may be referred to as "component 2", and one or more solvents selected from among alkyleneglycol monoalkyl ether carboxylic acid esters, alkoxycarboxylic acid esters, alicyclic ketones and acetic acid esters may be referred to as "component 3".

The present inventors have conducted much diligent research with the aim of solving the problems described above. As a result, it was found out that the cleaning removability of a pigment-containing photosensitive composition can be enhanced by using a removing solution with a specific composition, and the invention has been completed upon this finding.

Specifically, the invention comprises the following aspects, for example.
[1] A removing solution for photosensitive composition which is a removing solution for a pigment-containing photosensitive composition, the solution being characterized by comprising:
   (1) 95-70 mass% of an alkylene glycol monoalkyl ether and
   (2) 5-30 mass% of an aromatic hydrocarbon.
[2] A removing solution for photosensitive composition which is a removing solution for a pigment-containing photosensitive composition, the solution being characterized by comprising:
   (1) 85-20 mass% of an alkylene glycol monoalkyl ether,
   (2) 5-30 mass% of an aromatic hydrocarbon with nine or more carbon atoms, and
   (3) 10-75 mass% of at least one solvent selected from among alkylene glycol monoalkyl ether carboxylic acid esters, alkoxycarboxylic acid esters, alicyclic ketones and acetic acid esters.
[3] A removing solution for photosensitive composition according to claim 2, wherein the at least one solvent is selected from among alkylene glycol monoalkyl ether carboxylic acid esters, alkoxycarboxylic acid esters and alicyclic ketones.
[4] A removing solution for photosensitive composition according to claim 2, the solution being characterized by comprising:
   (1) 85-40 mass% of an alkylene glycol monoalkyl ether,
   (2) 5-30 mass% of an aromatic hydrocarbon with nine or more carbon atoms, and
   (3) 10-45 mass% of at least one solvent selected from among acetic acid esters.
[5] A removing solution for photosensitive composition according to any one of [1] to [4] above, characterized in that the aromatic hydrocarbon is an alkylbenzene with a boiling point of 150-250°C.
[6] A removing solution for photosensitive composition according to any one of [1] to [5] above, characterized in that the alkylene glycol monoalkyl ether is at least one selected from the group consisting of ethylene glycol monomethyl ether, ethylene glycol monoethyl ether, diethylene glycol monomethyl ether, diethylene glycol monoethyl ether, propylene glycol monomethyl ether, propylene glycol monoethyl ether, dipropylene glycol monomethyl ether, 3-methoxybutanol and 3-methyl-3-methoxybutanol.
[7] A removing solution for photosensitive composition according to [2], [3], [5] or [6] above, characterized in that the alkylene glycol monoalkyl ether carboxylic acid esters are one or more selected from the group consisting of propylene glycol monomethyl ether acetate, dipropylene glycol monomethyl ether acetate, 3-methoxybutyl acetate and 3-methyl-3-methoxybutyl acetate.
[8] A removing solution for photosensitive composition according to [2], [3], [5] or [6] above, characterized in that the alkoxycarboxylic acid esters are one or more selected from the group consisting of 3-methoxymethyl propionate and 3-ethoxyethyl propionate.
[9] A removing solution for photosensitive composition according to [2], [3], [5] or [6] above, characterized in that the alicyclic ketones are one or more selected from the group consisting of cyclohexanone, cyclopentanone and methylcyclohexanone.
[10] A removing solution for photosensitive composition according to any one of [2] or [4] to [6] above, characterized in that the acetic acid esters are one or more selected from the group consisting of ethyl acetate, n-propyl acetate, isopropyl acetate, n-butyl acetate, n-amyl acetate, isoamyl acetate and sec-amyl acetate.
[11] A removing solution for photosensitive composition according to any one of [1] to [10] above, which is used for removal of a pigment-containing acrylic photosensitive composition.
[12] A removing solution for photosensitive composition according to any one of [1] to [11] above, which is used for removal of a pigment-containing photosensitive composition prior to exposure to light.
[13] The use of a removing solution for photosensitive composition according to any one of [1] to [12] above for removing a pigment-containing photosensitive composition from an apparatus.
[14] The use of an apparatus according to [13] above, for producing a color filter.
[15] The use according to [14] above, wherein the apparatus provided with a color filter.
[16] The use of a removing solution for photosensitive composition according to any one of [1] to [12] above for removing a coloring pigment-containing photosensitive composition from a subtrate.

The removing solution for photosensitive composition of the invention can be effectively used for removal of pigment-containing photosensitive composition films remaining on the periphery, edges or backs of substrates in steps for formation of photosensitive composition films on substrates, or for removal of pigment-containing photosensitive compositions adhering to the surfaces of device members or equipment during the manufacturing of liquid crystal devices or organic EL devices, image sensors and the like.

### Best Mode for Carrying Out the Invention

Preferred embodiments of the removing solution for photosensitive composition of the invention will now be described.

The removing solution for photosensitive composition of the invention is used for removal of pigment-containing photosensitive compositions and comprises an alkylene glycol monoalkyl ether (component 1) and an aromatic hydrocarbon (component 2).

The alkylene glycol monoalkyl ether (component 1) used for the invention has high solubility for resin components in the photosensitive composition and is therefore preferably used as the main component of the photosensitive composition removing solution. As specific examples there may be mentioned ethylene glycol monomethyl ether, ethylene glycol monoethyl ether, ethylene glycol mono-n-propyl ether, ethylene glycol isopropyl ether, ethylene glycol mono-n-butyl ether, diethylene glycol monomethyl ether, diethylene glycol monoethyl ether, diethylene glycol monopropyl ether, diethylene glycol mono-n-butyl ether, propylene glycol monomethyl ether, propylene glycol monoethyl ether, propylene glycol monopropyl ether, propylene glycol mono-n-butyl ether, dipropylene glycol monomethyl ether, tripropylene glycol monomethyl ether, 3-methoxybutanol and 3-methyl-3-methoxybutanol, although the invention is not limited to these.

Preferred among the above are ethylene glycol monomethyl ether, ethylene glycol monoethyl ether, diethylene glycol monomethyl ether, diethylene glycol monoethyl ether, propylene glycol monomethyl ether, propylene glycol monoethyl ether, dipropylene glycol monomethyl ether, 3-methoxybutanol and 3-methyl-3-methoxybutanol, with propylene glycol monomethyl ether, 3-methoxybutanol and 3-methyl-3-methoxybutanol being especially preferred from the standpoint of high solubility of the photosensitive composition, availability and safety.

The aromatic hydrocarbon (component 2) in the removing solution for photosensitive composition of the invention is effective for maintaining dispersion of the pigment for removal of the pigment-containing photosensitive composition, thereby enhancing the pigment-removing performance of the removing solution. Component 2 of the invention is preferably an alkylsubstituted aromatic hydrocarbon, and there may be mentioned alkylbenzenes, alkylnaphthalenes and the like. The alkyl group may be straight-chain or branched, and two or more groups may be linked to form a ring structure. The aromatic hydrocarbon preferably has at least 9 and more preferably no greater than 12 carbon atoms. As specific examples of component 2 there may be mentioned alkylbenzenes such as 1,2,3-trimethylbenzene, 1,2,4-trimethylbenzene, 1,3,5-trimethylbenzene, 1-ethyl-2-methylbenzene, 1-ethyl-3-methylbenzene, 1-ethyl-4-methylbenzene, n-propylbenzene, cumene, n-butylbenzene, sec-butylbenzene, iso-butylbenzene, 1,2,3,4-tetramethylbenzene, 1,2,3,5-tetramethylbenzene, 1,2,4,5-tetramethylbenzene, 1,2-dimethyl-3-ethylbenzene, 1,2-dimethyl-4-ethylbenzene, 1,3-dimethyl-2-ethylbenzene, 1,3-dimethyl-4-ethylbenzene, 1,3-dimethyl-5-ethylbenzene, 1,4-dimethyl-2-ethylbenzene, 1-methyl-2-propylbenzene, 1-methyl-3-propylbenzene, 1-methyl-4-propylbenzene, 1-methyl-2-isopropylbenzene, 1-methyl-3-isopropylbenzene, 1-methyl-4-isopropylbenzene, 1,2-diethylbenzene, 1,3-diethylbenzene, 1,4-diethylbenzene, pentylbenzene, methylbutylbenzene, ethylpropylbenzene, dimethylpropylbenzene, methyldiethylbenzene, trimethylethylbenzene, pentamethylbenzene, hexylbenzene, methylpentylbenzene, ethylbutylbenzene, dimethylbutylbenzene, dipropylbenzene, methylethylpropylbenzene, trimethylpropylbenzene, triethylbenzene, dimethyldiethylbenzene, tetramethylethylbenzene, hexamethylbenzene, indane and tetrahydronaphthalene; and alkylnaphthalenes such as methylnaphthalene and dimethylnaphthalene, although the invention is not limited to these.

These aromatic hydrocarbons may be added alone to the photosensitive composition removing solution, or two or more of them may be added in combination.

Alkylbenzenes with boiling points of 150-250°C are preferred among the above from the viewpoint of performance for removal of photosensitive compositions, and especially high performance for removal of pigment-containing photosensitive compositions, as well as a drying property suitable for photosensitive composition removal.

Particularly preferred alkylbenzenes among the above are alkylbenzenes with nine or ten carbon atoms, and as specific examples there may be mentioned 1,2,3-trimethylbenzene, 1,2,4-trimethylbenzene, 1,3,5-trimethylbenzene, 1-ethyl-2-methylbenzene, 1-ethyl-3-methylbenzene, 1-ethyl-4-methylbenzene, n-propylbenzene, cumene, n-butylbenzene, sec-butylbenzene, iso-butylbenzene, 1,2,3,4-tetramethylbenzene, 1,2,3,5-tetramethylbenzene, 1,2,4,5-tetramethylbenzene, 1,2-dimethyl-3-ethylbenzene, 1,2-dimethyl-4-ethylbenzene, 1,3-dimethyl-2-ethylbenzene, 1,3-dimethyl-4-ethylbenzene, 1,3-dimethyl-5-ethylbenzene, 1,4-dimethyl-2-ethylbenzene, 1-methyl-2-propylbenzene, 1-methyl-3-propylbenzene, 1-methyl-4-propylbenzene, 1-methyl-2-isopropylbenzene, 1-methyl-3-isopropylbenzene, 1-methyl-4-isopropylbenzene, 1,2-diethylbenzene, 1,3-diethylbenzene, 1,4-diethylbenzene and the like.

The aromatic hydrocarbon may be prepared by any method for actual use of the removing solution of the invention, and it is effective to use solvent naphtha which has a high proportion of aromatic components, for example mostly C9 alkylbenzene-based mixed solvents, and mixtures of aromatic hydrocarbons such as SHELLSOL A (trademark of Shell Chemicals, Japan, initial boiling point: 160°C, dry point: 182°C), SOLVESSO 100 (trademark of Exxon Chemical Co., initial boiling point: 164°C, dry point: 176°C), SWASOL 1000 (trademark of Maruzen Petrochemical Co., Ltd., initial boiling point: 161°C, dry point: 179°C), IPSOL 100 (trademark of Idemitsu Kosan Co., Ltd., initial boiling point: 162°C, dry point: 179°C), HIGHSOL 100 (trademark of Nippon Petrochemicals Co., Ltd., initial boiling point: 155°C, dry point: 180°C), SOLFINE-TM (trademark of Showa Denko K.K., initial boiling point: 160°C, dry point: 180°C), a primarily C10 alkylbenzene-based mixed solvent such as SHELLSOL AB, (trademark of Shell Chemicals, Japan, initial boiling point: 187°C, dry point: 213°C), SOLVESSO 150 (trademark of Exxon Chemical Co., initial boiling point: 188°C, dry point: 209°C), SWASOL 1500 (trademark of Maruzen Petrochemical Co., Ltd., initial boiling point: 180.5°C, dry point: 208.5°C), IPSOL 150 (trademark of Idemitsu Kosan Co., Ltd., initial boiling point: 186°C, dry point: 205°C), HIGHSOL 150 (trademark of Nippon Petrochemicals Co., Ltd., initial boiling point: 182°C, dry point: 216°C), SOLFINE-WZ (trademark of Showa Denko K.K., initial boiling point: 195°C, dry point: 250°C), a primarily C10 or greater alkylbenzene-alkylnaphthalene-based mixed solvent such as SWASOL 1800, (trademark of Maruzen Petrochemical Co., Ltd., initial boiling point: 195.5°C, dry point: 245°C), and the like may be suitably used for the photosensitive composition removing solution of the invention.

Preferred proportions for component 1 and component 2 in the photosensitive composition removing solution of the invention are 95-70 mass% for component 1 and 5-30 mass% for component 2.

Contents of component 1 and component 2 in the photosensitive composition of the invention that are within these ranges will produce satisfactory solubility of resin components and other components in the photosensitive composition and dispersion and removal of the pigment.

The photosensitive composition removing solution of the invention also contains, in addition to the alkylene glycol monoalkyl ether (component 1) and aromatic hydrocarbon (component 2), also one or more solvents selected from among alkylene glycol monoalkyl ether carboxylic acid esters, alkoxycarboxylic acid esters, alicyclic ketones and acetic acid esters (component 3).

Component 3 which may be optionally added to the removing solution for photosensitive composition of the invention is effective in that it can enhance the solubility of the photosensitive composition by adjustment of the removing solution for photosensitive composition to a polarity more suitable for removal of the photosensitive composition, or it can increase the photosensitive composition removal speed by lowering the viscosity without reducing the solubility of the removing solution for photosensitive composition.

As specific examples of component 3 to be used for the invention there may be mentioned alkylene glycol monoalkyl ether carboxylic acid esters such as ethylene glycol monomethyl ether acetate, ethylene glycol monoethyl ether acetate, ethylene glycol monobutyl ether acetate, diethylene glycol monomethyl ether acetate, diethylene glycol monoethyl ether acetate, diethylene glycolmonobutyl ether acetate, propylene glycol monomethyl ether acetate, dipropylene glycol monomethyl ether acetate, 3-methoxybutyl acetate and 3-methyl-3-methoxybutyl acetate, alkoxycarboxylic acid esters such as 2-methoxymethyl acetate, 2-ethoxyethyl acetate, 3-ethoxyethyl propionate, 3-methoxymethyl propionate, 3-methoxyethyl propionate, 3-ethoxymethyl propionate, 2-methoxyethyl propionate, 2-ethoxypropyl propionate, 2-ethoxymethyl propionate, 2-ethoxyethyl propionate and β-methoxyisomethyl butyrate, alicyclic ketones such as cyclohexanone, cyclopentanone and methylcyclohexanone, and acetic acid esters such as ethyl acetate, n-propyl acetate, isopropyl acetate, n-butyl acetate, sec-butyl acetate, isobutyl acetate, amyl acetate, hexyl acetate and cyclohexyl acetate, although the invention is not limited to the above.

Among the above there are preferred propylene glycol monomethyl ether acetate, dipropylene glycol monomethyl ether acetate, 3-methoxybutyl acetate, 3-methyl-3-methoxybutyl acetate, 3-methoxymethyl propionate, 3-ethoxyethyl propionate, cyclohexanone, cyclopentanone, methylcyclohexanone, ethyl acetate, n-propyl acetate, isopropyl acetate, n-butyl acetate, n-amyl acetate, isoamyl acetate and sec-amyl acetate, from the viewpoint of removability, availability and safety of the photosensitive composition.

One each of an alkyleneglycol monoalkyl ether carboxylic acid ester, alkoxycarboxylic acid ester, alicyclic ketone and acetic acid ester may be used in the photosensitive composition removing solution of the invention, or combinations of two or more thereof may be used.

When the removing solution for photosensitive composition of the invention contains component 1, component 2 and component 3, the preferred proportions of component 1, component 2 and component 3 are 85-20 mass% for component 1, 5-30 mass% for component 2 and 10-75 mass% for component 3.

When component 3 is an alkylene glycol monoalkyl ether carboxylic acid ester, alkoxycarboxylic acid ester or alicyclic ketone, more preferred proportions for component 1, component 2 and component 3 are 85-20 mass% for component 1, 5-30 mass% for component 2 and 10-75 mass% for component 3, and when component 3 is an acetic acid ester, more preferred proportions for component 1, component 2 and component 3 are 85-40 mass% for component 1, 5-30 mass% for component 2 and 10-45 mass% for component 3.

If components 1-3 in the removing solution for photosensitive composition of the invention are within the aforementioned ranges, the resin solubility and dispersion and removal of the pigment will be satisfactory for removal of the pigment-containing photosensitive composition.

A coloring photosensitive resin composition for application of a removing solution according to the invention will now be explained in detail.

The colored photosensitive composition for application of a removing solution of the invention will generally be a pigment-containing colored photosensitive composition intended for use in a step of forming a color filter for a liquid crystal device or organic EL device, an image sensor or the like. Such colored photosensitive compositions are photosensitive compositions that are colored by inclusion of pigments, and they usually contain a film-forming substance capable of alkali development, a photosensitive substance and a pigment.

As film-forming substances to be included in the colored photosensitive composition there may be mentioned acrylic-based resins, novolac-based resins, polyimide-based resins, polyvinylphenol-based resins and the like, but the invention is particularly suited for removal of colored photosensitive compositions comprising acrylic-based resins as film-forming substances. The acrylic-based resins to be used as film-forming substances are alkali-soluble macromolecular polymers or copolymers with a molecular weight of about 1,000-500,000, and carboxyl group-containing ethylenic unsaturated monomers and their copolymers with other ethylenic unsaturated monomers are preferably used.

As photosensitive substances to be included in the colored photosensitive composition, when an acrylic-based resin is used as the film-forming substance, there may be mentioned hexaarylbiimidazole-based compounds, triazine-based compounds, aminoacetophenone-based compounds, combinations of sensitizing coloring matters with organic boron salt-based compounds, and titanocene-based compounds, oxadiazole-based compounds and the like.

Any pigments commonly used for production of color filters can be satisfactorily used as pigments in the colored photosensitive composition, and black, yellow, red, blue, green or other colored organic and inorganic pigments may be used alone or in mixtures as desired. As a specific examples of pigments there may be mentioned carbon black, acetylene black, lamp black, carbon nanotubes, graphite, iron black, iron oxide black pigments, aniline black, cyanine black, titanium black, C.I. Pigment Yellow 20, 24, 83, 86, 93, 109, 110, 117, 125, 137, 138, 139, 147, 148, 153, 154, 166, C.I. Pigment Orange-36, 43, 51, 55, 59, 61, C.I. Pigment Red 9, 97, 122, 123, 149, 168, 177, 180, 192, 215, 216, 217, 220, 223, 224, 226, 227, 228, 240, 254, C.I. Pigment Violet 19, 23, 29, 30, 37, 40, 50, C.I. Pigment Blue 15, 15:1, 15:4, 15:6, 22, 27, 60, 64, C.I. Pigment Green 7, 10, 36, 37, C.I. Pigment Brown 23, 25, 26 and the like.

The colored photosensitive composition may also contain an added ethylenic unsaturated monomer in addition to the aforementioned film-forming substance, photosensitive substance and pigments. An ethylenic unsaturated monomer is a compound that polymerizes by radicals generated from a photopolymerization initiator upon irradiation with active light rays.

The colored photosensitive composition for application of a removing solution for photosensitive composition according to the invention may further contain as appropriate, in addition to the components mentioned above, also organic solvents, pigment dispersants, adhesion enhancers, leveling agents, developing improvers, antioxidants, thermal polymerization inhibitors and the like.

The photosensitive composition removing solution of the invention can be applied for removal of colored photosensitive compositions that are coated or adhering onto substrates to be cleaned, and it can be used especially for removal of colored photosensitive compositions prior to exposure to light. The colored photosensitive composition may include a solvent, or it may be in a form with the solvent evaporated off.

The method for removing the colored photosensitive composition may be a method in which the cleaning fluid is sprayed from a nozzle, either as a stream, liquid droplets or a mist, onto a cleaning substrate with the colored photosensitive composition coated or adhering thereon, or a method in which a cleaning substrate onto which the colored photosensitive composition has adhered is dipped in the removing solution of the invention. For efficient removal, this may be accompanied by physical cleaning by ultrasonic irradiation or using a brush.

The removing solution for photosensitive composition of the invention can be applied for removal of the undesired uncured colored photosensitive composition adhering to the periphery, edges or back of a substrate in the step of applying a colored photosensitive composition during manufacture of a color filter to be used in a liquid crystal, organic EL, image sensor or the like, or for removal of the undesired uncured colored photosensitive composition adhering to all or a portion of the coating apparatus.

The removing solution for photosensitive composition of the invention can also be suitably applied as a rinsing agent for edge rinsing or back rinsing, for removal of uncured portions of a colored photosensitive composition on the periphery, edges or back surface of a substrate during coating of the colored photosensitive composition onto the substrate by spin coating, or for cup rinsing wherein the colored photosensitive composition that has splashed into the cup during spin coating is removed by cleaning.

Known methods for application of colored photosensitive compositions onto substrates other than spin coating include slit coating methods, wire bar coating methods and roll coating methods, but the removing solution for photosensitive composition of the invention may also be suitably used for removal of uncured colored photosensitive compositions adhering to the surfaces of coating apparatus members or tools such as slit nozzles, wire bars, printing plates and the like.

A different aspect of the invention is a substrate from which the uncured photosensitive composition has been removed by the method described above using the aforementioned photosensitive composition removing solution, an apparatus for manufacture of a liquid crystal device, organic EL device, image sensor or the like, and a color filter obtained using the apparatus.

The present invention will now be explained in greater detail using examples, naturally without any

The cleanability was evaluated on the following 3-level scale based on visual observation of the dissolved condition of the photosensitive coloring composition after immersion in the removing solution for 3 minutes.
G: Completely removed
F: Partially dissolved
P: Almost no dissolution

### Preparation Example 1: Preparation of acrylic copolymer

In a four-necked flask equipped with a dropping funnel, thermometer, condenser tube and stirrer there were charged 12.0 parts by mass of methacrylic acid (MA), 14.0 parts by mass of methyl methacrylate (MMA), 43.0 parts by mass of n-butyl methacrylate (BMA), 6.0 parts by mass of 2-hydroxyethyl acrylate (HEMA) and 225.0 parts by mass of ethylcellosolve acetate (EGA), and the four-necked flask was substituted with nitrogen for 1 hour. After heating to 90°C with an oil bath, a mixture of 12.0 parts by mass of MA, 14.0 parts by mass of MMA, 43.0 parts by mass of BMA, 6.0 parts by mass of HEMA, 225.0 parts by mass of EGA and 3.2 parts by mass of 2,2'-azobisisobutyronitrile (AIBN) was added dropwise over a period of one hour. After 3 hours of polymerization, a mixture of 1.0 part by mass of AIBN and 15.0 parts by mass of EGA was added and the temperature was further increased to 100°C for 1.5 hours of polymerization, followed by cooling. The solid concentration of the acrylic copolymer obtained in this manner was 22.1 mass%, the acid value was 92 mgKOH/g, and the weight-average molecular weight was 22,000 based on polystyrene, as measured by GPC.

### Preparation Example 2: Preparation of photosensitive coloring composition A: Black photosensitive coloring composition

After combining 30.0 part by mass of the acrylic copolymer obtained in Preparation Example 1 (solid content: 6.6 parts by mass), 5.0 parts by mass of EGA, 3.3 parts by mass of FLOWLEN DOPA-33 (trademark of Kyoeisha Chemical Co., Ltd., dispersing agent, solid concentration: 30 mass%) and 6.6 parts by mass of Special Black 4 (carbon black by Degussa), the mixture was allowed to stand overnight. After stirring for one hour, it was passed four times through a triple roll mill (Model RIII-1RM-2 by Kodaira Seisakusho Co., Ltd.). EGA was added to the obtained black ink for concentration adjustment to obtain a black coloring composition with a solid concentration of 18.0 mass%.

To 100 parts by mass of the black coloring composition obtained in this manner there were further added 4.4 parts by mass of dipentaerythritol hexaacrylate, 2.2 parts by mass of 2-(4-methoxyphenyl)-4,6-bis(trichloromethyl)-s-triazine and 25 parts by mass of EGA, and the mixture was thoroughly stirred to obtain photosensitive coloring composition A.

### Preparation Example 3: Preparation of photosensitive coloring composition B: Green photosensitive coloring composition

After combining 30.0 parts by mass of the acrylic copolymer obtained in Preparation Example 1 (solid content: 6.6 parts by mass), 5.0 parts by mass of EGA, 3.3 parts by mass of FLOWLEN DOPA-33 (trademark of Kyoeisha Chemical Co., Ltd., dispersing agent, solid concentration: 30 mass%) and 6.6 parts by mass of Pigment Green 36, the mixture was allowed to stand overnight. After stirring for one hour, it was passed four times through a triple roll mill (Model RIII-1RM-2 by Kodaira Seisakusho Co., Ltd.). EGA was added to the obtained green ink for concentration adjustment to obtain a green coloring composition with a solid concentration of 18.0 mass%.

To 100 parts by mass of the green coloring composition obtained in this manner there were further added 4.4 parts by mass of dipentaerythritol hexaacrylate, 0.7 part by mass of 4,4'-bis(N,N-diethylamino)benzophenone, 2.3 parts by mass of 2,2'-bis(o-chlorophenyl)-4,4',5,5'-tetraphenyl-1,2'-biimidazole, 3.8 parts by mass of trimethylolpropane tristhiopropionate and 42 parts by mass of EGA, and the mixture was thoroughly stirred to obtain photosensitive coloring composition B.

### Preparation Example 4: Preparation of photosensitive coloring composition C: Red photosensitive coloring composition

After combining 30.0 parts by mass of the acrylic copolymer obtained in Preparation Example 1 (solid content: 6.6 parts by mass), 5.0 parts by mass of EGA, 3.3 parts by mass of FLOWLEN DOPA-33 (trademark of Kyoeisha Chemical Co., Ltd., dispersing agent, solid concentration: 30 mass%) and 6.6 parts by mass of Pigment Red 177, the mixture was allowed to stand overnight. After stirring for one hour, it was passed four times through a triple roll mill (Model RIII-1RM-2 by Kodaira Seisakusho Co., Ltd.). EGA was added to the obtained red ink for concentration adjustment to obtain a red coloring composition with a solid concentration of 18.0 mass%. To 100 parts by mass of the coloring composition there were added 4.4 parts by mass of dipentaerythritol hexaacrylate, 3.0 parts by mass of IRGACURE 369 (Ciba Specialty Chemicals, Inc.), 3.8 parts by mass of trimethylolpropane tristhiopropionate and 42 parts by mass of EGA, and the mixture was thoroughly stirred to obtain photosensitive coloring composition C.

### Example 1

One drop each of the photosensitive coloring compositions A-C prepared in Preparation Examples 2-4 was dropped onto a glass substrate (28 mm x 76 mm) and then dried for 24 hours at room temperature.

The substrate was then dipped and allowed to stand for 3 minutes in a removing solution comprising a mixture of 70 g of propylene glycol monomethyl ether and 30 g of SOLFINE-TM (Showa Denko K.K.), for cleaning removal of the photosensitive coloring composition coated on the surface. The results are shown in Table 1.

### Examples 2-21, Comparative Examples 1-4

Removing solutions with the compositions shown in Table 1 were used for removal of the photosensitive coloring composition in the same manner as Example 1. The results are shown in Table 1.

**Table 1**

| | | Cleaning solution composition (mass%) | | | | | | | | | | | | | Cleanability | | |
|---|---|---|---|---|---|---|---|---|---|---|---|---|---|---|---|---|---|
| | | Component 1 | | | Component 2 | | | Component 3 | | | | | | | Photosensitive coloring composition | | |
| | | PM | DPM | MB | S-TM | TMB | CUM | PMA | MBA | MMP | EEP | BA | CYA | CYP | A (black) | B (green) | C (red) |
| Example | 1 | 70 | | | 30 | | | | | | | | | | G | F | G |
| | 2 | | 80 | | | 20 | | | | | | | | | F | F | G |
| | 3 | 40 | | | 30 | | | 30 | | | | | | | G | F | G |
| | 4 | 55 | | | | | 20 | 25 | | | | | | | G | G | G |
| | 5 | | 50 | | 20 | | | 30 | | | | | | | G | F | G |
| | 6 | 60 | | | 20 | | | | 20 | | | | | | G | G | G |
| | 7 | 40 | | | 10 | | | | 50 | | | | | | G | G | G |
| | 8 | | | 40 | 20 | | | | 40 | | | | | | G | G | G |
| | 9 | 30 | | | 10 | | | | | 60 | | | | | G | G | G |
| | 10 | 60 | | | 20 | | | | | 20 | | | | | G | G | G |
| | 11 | 60 | | | 20 | | | | | | 20 | | | | G | G | G |
| | 12 | | 20 | | 20 | | | | | | 60 | | | | G | F | G |
| | 13 | 30 | | | 20 | | | | | | | 50 | | | F | F | G |
| | 14 | 50 | | | 20 | | | | | | | 30 | | | G | G | G |
| | 15 | 60 | | | 30 | | | | | | | 10 | | | G | G | G |
| | 16 | 20 | | | 20 | | | | | | | | 60 | | G | G | G |
| | 17 | 60 | | | 20 | | | | | | | | 20 | | G | G | G |
| | 18 | 20 | | | | 20 | | | | | | | 60 | | G | G | G |
| | 19 | 40 | | | | 20 | | | | | | | 40 | | G | G | G |
| | 20 | | | 30 | 20 | | | | | | | | 50 | | G | G | G |
| | 21 | 50 | | | 20 | | | | | | | | | 30 | G | G | G |
| Comp. Example | 1 | 100 | | | | | | | | | | | | | P | F | F |
| | 2 | | | | 100 | | | | | | | | | | P | P | P |
| | 3 | | | | | | | 100 | | | | | | | F | F | F |
| | 4 | 70 | | | | | | 30 | | | | | | | F | F | F |

| | | | | | | | | | | | | | | | | | |
|---|---|---|---|---|---|---|---|---|---|---|---|---|---|---|---|---|---|
| Abbreviations: PM: Propylene glycol monomethyl ether PMA: Propylene glycol monomethyl ether acetate DPM: Dipropylene glycol monomethyl ether MBA: 3-Methoxybutyl acetate MB: 3-Methoxybutanol MMP: 3-Methoxymethyl propionate TMB: 1,2,4-Trimethylbenzene EEP: 3-Ethoxyethyl propionate CUM: Cumene CYA: Cyclohexanone S-TM: SOLFINE-TM (Showa Denko K.K.) CYP: Cyclopentanone | | | | | | | | | | | | | | | | | |

### Industrial Applicability

The invention provides a removing solution for photosensitive composition that is useful for removal of pigment-containing photosensitive composition films remaining on the periphery, edges or backs of substrates in steps for formation of photosensitive composition films on substrates during the manufacturing of liquid crystal devices or organic EL devices, image sensors and, the like, or for removal of pigment-containing photosensitive compositions adhering to the surfaces of device members or equipment.

## Claims

1. A removing solution for photosensitive composition which is a removing solution for a pigment-containing photosensitive composition, the solution being **characterized by** comprising:
(1) 95-70 mass% of an alkylene glycol monoalkyl ether and
(2) 5-30 mass% of an aromatic hydrocarbon.

2. A removing solution for photosensitive composition which is a removing solution for a pigment-containing photosensitive composition, the solution being **characterized by** comprising:
(1) 85-20 mass% of an alkylene glycol monoalkyl ether,
(2) 5-30 mass% of an aromatic hydrocarbon with nine or more carbon atoms, and
(3) 10-75 mass% of at least one solvent selected from among alkylene glycol monoalkyl ether carboxylic acid esters, alkoxycarboxylic acid esters, alicyclic ketones and acetic acid esters.

3. A removing solution for photosensitive
composition according to claim 2, wherein the
at least one solvent is selected from among alkylene glycol monoalkyl ether carboxylic acid esters, alkoxycarboxylic acid esters and alicyclic ketones.

4. A removing solution for photosensitive composition according to claim 2, the solution being **characterized by** comprising:
(1) 85-40 mass% of an alkylene glycol monoalkyl ether,
(2) 5-30 mass% of an aromatic hydrocarbon with nine or more carbon atoms, and
(3) 10-45 mass% of at least one solvent selected from among acetic acid esters.

5. A removing solution for photosensitive composition according to any one of claims 1 to 4, **characterized in that** the aromatic hydrocarbon is an alkylbenzene with a boiling point of 150-250°C.

6. A removing solution for photosensitive composition according to any one of claims 1 to 5, **characterized in that** the alkylene glycol monoalkyl ether is at least one selected from the group consisting of ethylene glycol monomethyl ether, ethylene glycol monoethyl ether, diethylene glycol monomethyl ether, diethylene glycol monoethyl ether, propylene glycol monomethyl ether, propylene glycol monoethyl ether, dipropylene glycol monomethyl ether, 3-methoxybutanol and 3-methyl-3-methoxybutanol.

7. A removing solution for photosensitive composition according to claim 2, 3, 5 or 6, **characterized in that** the alkylene glycol monoalkyl ether carboxylic acid ester is at least one selected from the group consisting of propylene glycol monomethyl ether acetate, dipropylene glycol monomethyl ether acetate, 3-methoxybutyl acetate and 3-methyl-3-methoxybutyl acetate.

8. A removing solution for photosensitive composition according to claim 2, 3, 5 or 6, wherein the alkoxycarboxylic acid ester is at least one selected from the group consisting of 3-methoxymethyl propionate and 3-ethoxyethyl propionate.

9. A removing solution for photosensitive composition according to claim 2, 3, 5 or 6, **characterized in that** the alicyclic ketone is at least one selected from the group consisting of cyclohexanone, cyclopentanone and methylcyclohexanone.

10. A removing solution for photosensitive composition according to any one of claims 2 or 4-6, **characterized in that** the acetic acid ester is at least one selected from the group consisting of ethyl acetate, n-propyl acetate, isopropyl acetate, n-butyl acetate, n-amyl acetate, isoamyl acetate and sec-amyl acetate.

11. A removing solution for photosensitive composition according to any one of claims 1 to 10, which is used for removal of a pigment-containing acrylic photosensitive composition.

12. A removing solution for photosensitive composition according to any one of claims 1 to 11, which is used for removal of a pigment-containing photosensitive composition prior to exposure to light.

13. The use of for removing a repigment-containing photosensitive composition from an apparatus a removing solution for photosensitive composition according to any one of claims 1 to 12

14. The use of an apparatus according to claim 13 for producing a color filter.

15. The use
according to claim 14, wherein the apparatus is provided with a color filter 16. The use of a removing solution for photosensitive composition according to any one of claims 1 to 12 for removing a coloring pigment-containing photosensitive composition from a substrate.

## Patentansprüche

1. Lösung zum Entfernen einer lichtempfindlichen Zusammensetzung, die eine Lösung zum Entfernen einer pigmenthaltigen lichtempfindlichen Zusammensetzung ist, wobei die Lösung **dadurch gekennzeichnet ist, dass** sie enthält:
(1) 95-70 Massen-% eines Alkylenglycolmonoalkylethers
und
(2) 5-30 Massen-% eines aromatischen Kohlenwasserstoffs.

2. Lösung zum Entfernen einer lichtempfindlichen Zusammensetzung, die eine Lösung zum Entfernen einer pigmenthaltigen lichtempfindlichen Zusammensetzung ist, wobei die Lösung **dadurch gekennzeichnet ist, dass** sie enthält:
(1) 85-20 Massen-% eines Alkylenglycolmonoalkylethers,
(2) 5-30 Massen-% eines aromatischen Kohlenwasserstoffs mit 9 oder mehr Kohlenstoffatomen und
(3) 10-75 Massen-% mindestens eines Lösungsmittels, das unter Alkylenglycolmonoalkylethercarbonsäureestern, Alkoxycarbonsäureestern, alicyclischen Ketonen und Essigsäureestern ausgewählt ist.

3. Lösung zum Entfernen einer lichtempfindlichen Zusammensetzung nach Anspruch 2, wobei die mindestens eine Lösung unter Alkylenglycolmonoalkylethercarbonsäureestern, Alkoxycarbonsäureestern und alicyclischen Ketonen ausgewählt ist.

4. Lösung zum Entfernen einer lichtempfindlichen Zusammensetzung nach Anspruch 2, wobei die Lösung **dadurch gekennzeichnet ist, dass** sie enthält:
(1) 85-40 Massen-% eines Alkylenglycolmonoalkylethers,
(2) 5-30 Massen-% eines aromatischen Kohlenwasserstoffs mit 9 oder mehr Kohlenstoffatomen und
(3) 10-45 Massen-% mindestens eines unter Essigsäureestern ausgewählten Lösungsmittels.

5. Lösung zum Entfernen einer lichtempfindlichen Zusammensetzung nach einem der Ansprüche 1 bis 4, **dadurch gekennzeichnet, dass** der aromatische Kohlenwasserstoff ein Alkylbenzol mit einem Siedepunkt von 150 bis 250 °C ist.

6. Lösung zum Entfernen einer lichtempfindlichen Zusammensetzung nach einem der Ansprüche 1 bis 5, **dadurch gekennzeichnet, dass** der Alkylenglycolmonoalkylether mindestens einer ist, der aus der Gruppe ausgewählt ist, die aus Ethylenglycolmonomethylether, Ethylenglycolmonoethylether, Diethylenglycolmonomethylether, Diethylenglycolmonoethylether, Propylenglycolmonomethylether, Propylenglycolmonoethylether, Dipropylenglycolmonomethylether, 3-Methoxybutanol und 3-Methyl-3-methoxybutanol besteht.

7. Lösung zum Entfernen einer lichtempfindlichen Zusammensetzung nach Anspruch 2, 3, 5 oder 6, **dadurch gekennzeichnet, dass** der Alkylenglycolmonoalkylether-Carbonsäureester mindestens einer ist, der aus der Gruppe ausgewählt ist, die aus Propylenglycolmonomethyletheracetat, Dipropylenglycolmonomethyletheracetat, 3-Methoxybutylacetat und 3-Methyl-3-methoxybutylacetat besteht.

8. Lösung zum Entfernen einer lichtempfindlichen Zusammensetzung nach Anspruch 2, 3, 5 oder 6, wobei der Alkoxycarbonsäureester mindestens einer ist, der aus der Gruppe ausgewählt ist, die aus 3-Methoxymethylprpionat und 3-Ethoxyethylpropionat besteht.

9. Lösung zum Entfernen einer lichtempfindlichen Zusammensetzung nach Anspruch 2, 3, 5 oder 6, **dadurch gekennzeichnet, dass** das alicyclische Keton mindestens eines ist, das aus der Gruppe ausgewählt ist, die aus Cyclohexanon, Cyclopentanon und Methylcyclohexanon besteht.

10. Lösung zum Entfernen einer lichtempfindlichen Zusammensetzung nach einem der Ansprüche 2 oder 4 bis 6, **dadurch gekennzeichnet, dass** der Essigsäureester mindestens einer ist, der aus der Gruppe ausgewählt ist, die aus Ethylacetat, n-Propylacetat, Isopropylacetat, n-Butylacetat, n-Amylacetat, Isoamylacetat und sec-Amylacetat besteht.

11. Lösung zum Entfernen einer lichtempfindlichen Zusammensetzung nach einem der Ansprüche 1 bis 10, die zum Entfernen einer pigmenthaltigen acrylischen lichtempfindlichen Zusammensetzung eingesetzt wird.

12. Lösung zum Entfernen einer lichtempfindlichen Zusammensetzung nach einem der Ansprüche 1 bis 11, die zum Entfernen einer pigmenthaltigen lichtempfindlichen Zusammensetzung vor der Bestrahlung mit Licht verwendet wird.

13. Verwendung einer Lösung zum Entfernen einer lichtempfindlichen Zusammensetzung nach einem der Ansprüche 1 bis 12 zum Entfernen einer pigmenthaltigen lichtempfindlichen Zusammensetzung aus einem Apparat.

14. Verwendung eines Apparates nach Anspruch 13 zum Herstellen eines Farbfilters.

15. Verwendung nach Anspruch 14, wobei der Apparat mit einem Farbfilter versehen ist.

16. Verwendung einer Lösung zum Entfernen einer lichtempfindlichen Zusammensetzung nach einem der Ansprüche 1 bis 12 zum Entfernen einer farbpigmenthaltigen lichtempfindlichen Zusammensetzung von einem Substrat.

## Revendications

1. Solution d'élimination pour composition photosensible qui est une solution d'élimination pour une composition photosensible contenant un pigment, la solution étant **caractérisée en ce qu'**elle comprend :
(1) 95-70 % en masse d'un éther monoalkylique d'alkylène glycol et
(2) 5-30 % en masse d'un hydrocarbure aromatique.

2. Solution d'élimination pour composition photosensible qui est une solution d'élimination pour une composition photosensible contenant un pigment, la solution étant **caractérisée en ce qu'**elle comprend :
(1) 85-20 % en masse d'un éther monoalkylique d'alkylène glycol,
(2) 5-30 % en masse d'un hydrocarbure aromatique avec neuf atomes de carbone ou plus, et
(3) 10-75 % en masse d'au moins un solvant choisi parmi les esters d'acide carboxylique d'éther monoalkylique d'alkylène glycol, les esters d'acide alcoxycarboxylique, les cétones alicycliques et les esters d'acide acétique.

3. Solution d'élimination pour composition photosensible selon la revendication 2, dans laquelle l'au moins un solvant est choisi parmi l'éther monoalkylique d'alkylène glycol, les esters d'acide carboxylique, les esters d'acide alcoxycarboxylique et les cétones alicycliques.

4. Solution d'élimination pour composition photosensible selon la revendication 2, la solution étant **caractérisée en ce qu'**elle comprend :
(1) 85-40 % en masse d'un éther monoalkylique d'alkylène glycol,
(2) 5-30 % en masse d'un hydrocarbure aromatique avec neuf atomes de carbone ou plus, et
(3) 10-45 % en masse d'au moins un solvant choisi parmi les esters d'acide acétique.

5. Solution d'élimination pour composition photosensible selon l'une quelconque des revendications 1 à 4, **caractérisée en ce que** l'hydrocarbure aromatique est un alkylbenzène avec un point d'ébullition de 150 à 250°C.

6. Solution d'élimination pour composition photosensible selon l'une quelconque des revendications 1 à 5, **caractérisée en ce que** l'éther monoalkylique d'alkylène glycol est au moins un élément choisi parmi le groupe constitué d'éther monométhylique d'éthylène glycol, éther monoéthylique d'éthylène glycol, éther monométhylique de diéthylène glycol, éther monoéthylique de diéthylène glycol, éther monométhylique de propylène glycol, éther monoéthylique de propylène glycol, éther monométhylique de dipropylène glycol, 3-méthoxybutanol et de 3-méthyl-3-méthoxybutanol.

7. Solution d'élimination pour composition photosensible selon la revendication 2, 3, 5 ou 6, **caractérisée en ce que** l'ester d'acide carboxylique d'éther monoalkylique d'alkylène glycol est au moins un élément choisi parmi le groupe constitué d'acétate d'éther monométhylique de propylène glycol, acétate d'éther monométhylique de dipropylène glycol, acétate de 3-méthoxybutyle, et d'acétate de 3-méthyl-3-méthoxybutyle.

8. Solution d'élimination pour composition photosensible selon la revendication 2, 3, 5 ou 6, dans laquelle l'ester d'acide alcoxycarboxylique est au moins un élément choisi parmi le groupe constitué de propionate de 3-méthoxyméthyle et de propionate de 3-éthoxyéthyle.

9. Solution d'élimination pour composition photosensible selon la revendication 2, 3, 5 ou 6, **caractérisée en ce que** la cétone alicyclique est au moins un élément choisi parmi le groupe constitué de cyclohexanone, cyclopentanone et de méthylcyclohexanone.

10. Solution d'élimination pour composition photosensible selon l'une quelconque des revendications 2 ou 4-6, **caractérisée en ce que** l'ester d'acide acétique est au moins un élément choisi parmi le groupe constitué d'acétate d'éthyle, acétate de n-propyle, acétate d'isopropyle, acétate de n-butyle, acétate de n-amyle, acétate d'isoamyle et d'acétate de sec-amyle.

11. Solution d'élimination pour composition photosensible selon l'une quelconque des revendications 1 à 10, qui est utilisée pour éliminer une composition photosensible acrylique contenant un pigment.

12. Solution d'élimination pour composition photosensible selon l'une quelconque des revendications 1 à 11, qui est utilisée pour éliminer une composition photosensible contenant un pigment avant exposition à la lumière.

13. Utilisation d'une solution d'élimination pour composition photosensible selon l'une quelconque des revendications 1 à 12 pour éliminer, d'un appareil, une composition photosensible contenant un pigment.

14. Utilisation d'un appareil selon la revendication 13 pour produire un filtre coloré.

15. Utilisation selon la revendication 14, dans laquelle l'appareil est pourvu d'un filtre coloré.

16. Utilisation d'une solution d'élimination pour composition photosensible selon l'une quelconque des revendications 1 à 12 pour éliminer, d'un substrat, une composition photosensible contenant un pigment colorant.
